# EUROPEAN PATENT SPECIFICATION

(11) **EP 2 190 025 B1**
(45) Date of publication and mention of the grant of the patent: **20.03.2013**
(21) Application number: 09175869.8
(22) Date of filing: 12.11.2009
(51) Int. Cl.: H01L 31/0236, H01L 27/146, G02B 1/11

(54) **Imaging assembly**
Bildgebungsanordnung
Ensemble d'imagerie

(30) Priority: 25.11.2008 GB 0821504
(43) Date of publication of application: 26.05.2010
(73) Proprietor: STMicroelectronics (Research & Development) Limited, Marlow, Buckinghamshire SL7 1YL (GB)
(72) Inventor: Findlay, Ewan, Dollar, Fife FK14 7ES (GB); McGarry, Colin, Edinburgh, Lothian EH52 5AT (GB)
(74) Representative: McBride, Peter Hill

(56) References cited:
- EP-A2- 1 008 453
- EP-A2- 1 560 271
- EP-A2- 2 094 000
- WO-A2-2004/027880
- US-A- 5 444 520
- US-A1- 2002 000 244
- US-A1- 2005 226 608
- US-A1- 2006 227 834

## Description

The present invention relates to an imaging assembly and particularly, but not exclusively, to an imaging assembly for use with solid state or wafer scale image sensors and a method of manufacturing said imaging assembly.

Solid state or wafer scale image sensors are incorporated into low cost cameras and other devices, such as mobile cellular telephones and personal digital assistants, optical devices and medical imaging devices.

It is known to provide wafer scale miniature cameras incorporating lenses produced using over-moulding techniques on glass substrates which can survive the high temperature solder reflow processes used in the manufacture of such devices. Such lenses are usually stacked together, separated by spacer members to provide an air gap between each lens.

Currently non-light transmissive surfaces of such lens arrangements, for example the inner faces of the spacer members, are coated with an anti-reflection coating, such as a black material. While such coating reduces reflections, it does not eliminate them. Thus these surfaces define a low reflectivity specular reflector in the system. A typical reflectance of such coated surfaces may be 4% or more which will produce undesirable ghost images and other stray light effects in the image plane of such an imaging assembly.

Furthermore, the surfaces of the glass wafer used as substrates for the lenses will reflect light outside the lens aperture. The intensity of the reflected light will be around 4% of the incident intensity, increasing with angle of incidence, and will not be dissipated by diffuse reflections.

Currently air-cavity chip scale packages (AC-CSP) have been developed for encapsulating CMOS image sensors. A typical chip scale package consists of a silicon wafer onto which the CMOS sensor is built by standard semiconductor processes, a spacer member comprising a wall structure mounted onto the wafer to hold a fixed "air- cavity" between the sensor surface and a glass package lid mounted on the spacer member. The electrical contacts to the CMOS sensor are typically made by routing from custom connection pads on front of the silicon wafer to pads.

It is necessary to expansion match all parts of the assembly. The glass material of the spacer member and the package lid is near expansion matched to the silicon of the wafer. Therefore it is not possible to apply anti-reflection coatings to the components of the assembly, partly due to the stresses that reliable high quality (low surface defect occurrence) thin-film dielectric interference coatings place on the glass wafer. These stresses result in deviations in flatness and warping of the glass which affects either the process of bonding the glass spacer member and package lid to the silicon wafer, or the stresses generated in the silicon as it holds the glass in tension. This later problem results in the silicon wafer cracking as it is back-lapped (ground down to a required thickness) whilst attached to the package lid prior to the application of the rear layer of the assembly and singulation of the glass/silicon structure to form final chip scale package.

US 5,444,520 discloses an image device for reducing the degradation in an image formation process due to temperature variation. The imaging device comprises sidewalls and light shielding plates made of a liquid crystalline polymer so the coefficients of thermal expansion can be made zero or negative. The shielding plates can be provided with anti-reflection faces comprising sewteeth-shaped roughness to prevent incident rays from a LED array to reach the lens of the imaging device.

US 2006/0227834 discloses a member having an anti-reflection structure to improve the image characteristics of an optical device. The anti-reflection structure comprises elements having the shape of a cone with a height of 150 nanometres arranged in an array form at a period smaller than the wavelengths range of the visible light. The height of the structural elements being equal to or more than the period.

EP1008453 discloses an optical printer head comprising a surface of a reflection region forming a scattering surface which carries out irregular reflection of light incidents thereon.

WO 2004/027880 discloses a camera device comprising a lens element, an image capturing element and a spacer means for maintaining a predetermined distance between a lens and the image capturing element wherein the spacer means comprises an adhesive layer.

EP1560271 discloses an optical device with a base of ring shape. The upper surface of the base is formed with a tapered recess. A gap is formed between the tapered recess and a transparent plate attached to the base. The gap is formed with an adhesive layer to maintain the mechanical adhesion strength between the base and the transparent plate.

Therefore, there is a need to reduce unwanted internal reflections within such imaging assemblies without requiring expensive and often unsuitable anti-reflection coatings.

According to a first aspect of the present invention there is provided an imaging assembly according to claim 1.

The anti-reflection structure preferably comprises a plurality of projections having a height less than the wavelength of visible light, typically between 200 and 800 nm.

At least a portion of the anti-reflection structure may be coated with an optically absorbent material, such as carbon loaded epoxy resin.

In preferred embodiments the imaging assembly further comprises a solid state image sensor provided or mounted on said substrate.

Preferably the imaging assembly comprises a wafer scale lens wherein said first optical layer comprises an at least partially transparent member having an upper surface and a lower surface, a lens being provided on at least one of said upper and lower surfaces, the inner faces of said spacer member facing said air gap being provided with said anti-reflection structure.

The imaging assembly may comprise a further spacer member mounted on the upper surface of the optical layer, a further optical layer being mounted on said further spacer member to be spaced above said first optical layer, the further optical layer having an upper surface and a lower surface, a lens being provided on at least one of said upper and lower surfaces thereof, the inner faces of said further spacer member facing the gap between said first and further optical layers being provided with said anti-reflection structure.

There may be a plurality of further spacer members and a plurality of further optical layers arranged in a coaxial stacked relationship upon said first optical layer, each further spacer member being provided with said anti-reflective structure on the inner faces thereof.

The imaging assembly may suitably comprise a CMOS image sensor, said substrate comprising a silicon wafer having an image sensor formed thereon, said spacer member comprising a wall structure attached to said substrate to encompass said image sensor, said first optical layer comprising a cover attached to said spacer member to define a closed cavity over said image sensor, the inner faces of said spacer member and said first optical layer exposed to said air gap being provided with said anti-reflection structure.

The substrate and/or the optical layer may be provided with surface features to aid alignment of the spacer member upon the substrate and/or the optical layer to improve adhesion of the spacer member thereto. Said surface features may comprise a roughened surface region to improve adhesion of the spacer means to the substrate and/or the optical layer. Alternatively, said surface features may comprise raised formations to aid location of the spacer member on the substrate and to reduce stresses at the junction of the spacer member and the substrate and/or the optical layer.

From another aspect, the present invention provides a method of manufacturing an imaging assembly according to claim 9.

Said anti-reflection structure may be formed by one or more of direct lithographic etching, laser ablation techniques, transfer moulding, embossing processes, or fine sand blasting or grinding of the surfaces with a fine grit.

Said anti-reflection structure may be formed in the same step as forming a lens on one or both of said upper and lower surfaces of the optical layer. In a preferred embodiment, said anti-reflection structure is formed over substantially all of one or both of said upper and lower surfaces and over-moulding one or more optical components on at least a portion of the anti-reflection structure on one or both of an upper and a lower surface of said optical layer.

The method preferably includes providing an image sensor on or mounted on said substrate, said method comprising forming said anti-reflection structure on a region of said substrate around said image sensor.

The method may further comprise coating at least a portion of the anti-reflection structure with an optically absorbent material, such as carbon loaded epoxy resin.

The imaging assembly of the invention may be incorporated in a mobile device such as a mobile cellular telephone or a camera; or in a medical device comprising such as an endoscope; or in an optical pointing device.

Embodiments of the invention will now be described with reference to the accompanying drawings, in which:-
Fig. 1 illustrates an imaging assembly according to an example of the present invention;
Fig. 2A is a perspective view of one form of moth eye structure;
Fig. 2B is a side view corresponding to Fig. 2A;
Fig. 3 shows steps in implementing one form of the invention;
Fig. 4 shows a moth eye structure combined with an absorber;
Fig. 5 illustrates an imaging assembly according to an example of the present invention;
Fig. 6 is a plan view of a package lid used in one example of the invention;
Fig. 7 is a perspective view of a spacer element used in one example of the invention; and
Fig. 8 is a side view showing use of another form of spacer member.

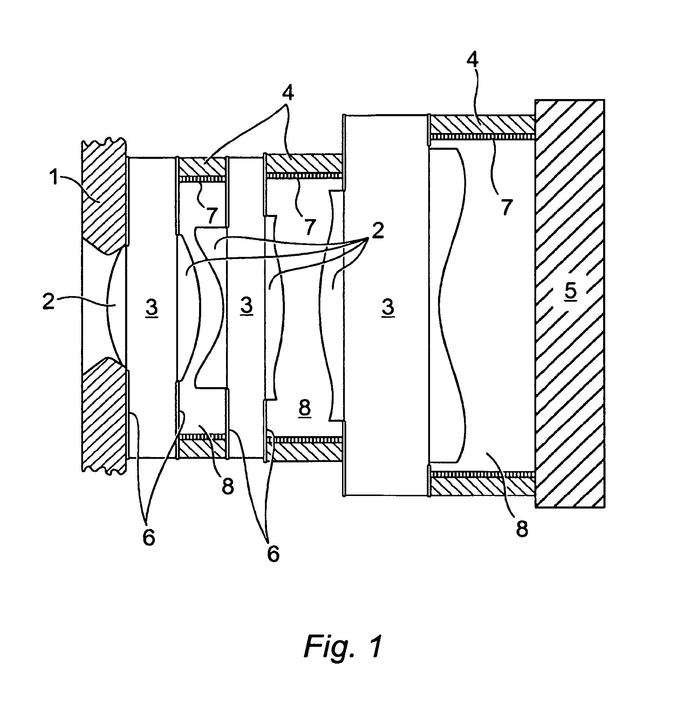

Figure 1 illustrates an example not forming the part of the present invention said example being necessary for understanding it.

As illustrated in Figure 1, a wafer scale lens may consist of a stacked arrangement of components, comprising, from the outermost component to the innermost, a cover 1, which provides baffling from the outside world and extends around the outermost lens element 2 to prevent light entering other than by the aperture stop, a plurality of lens elements 2 implemented by over-moulded features on substrate glass wafers 3, the lens elements 2 being separated by spacer members 4 which hold the lens elements 2 at fixed separation from each and from an image sensor provided on a substrate 5. Air gaps 8 are therefore formed between the substrate wafers 3 and lenses 2, and within the spacers 4.

From Figure 1 it is obvious that there are a large number of flat glass surfaces present around the lens elements 2 and also between the lens elements 2. These flat surfaces 6 will leak and/or reflect stray light back into the camera system, and as such would normally require an absorption coating insensitive to angle of incidence.

In accordance with an example, such flat surfaces are provided with a motheye structure, namely a motheye structure 6 on those parts of the substrates 3 which surround the lens elements 2, and a motheye structure 7 on the interior surfaces of the spacer members 4.

Such moth eye structures comprise a nanoscale relief structure comprising projections having a height of the order of 200 to 600 nm, i.e. smaller than the wavelength of visible light. Such structures, resembling that of a moth's eye, are known to suppress surface reflections.

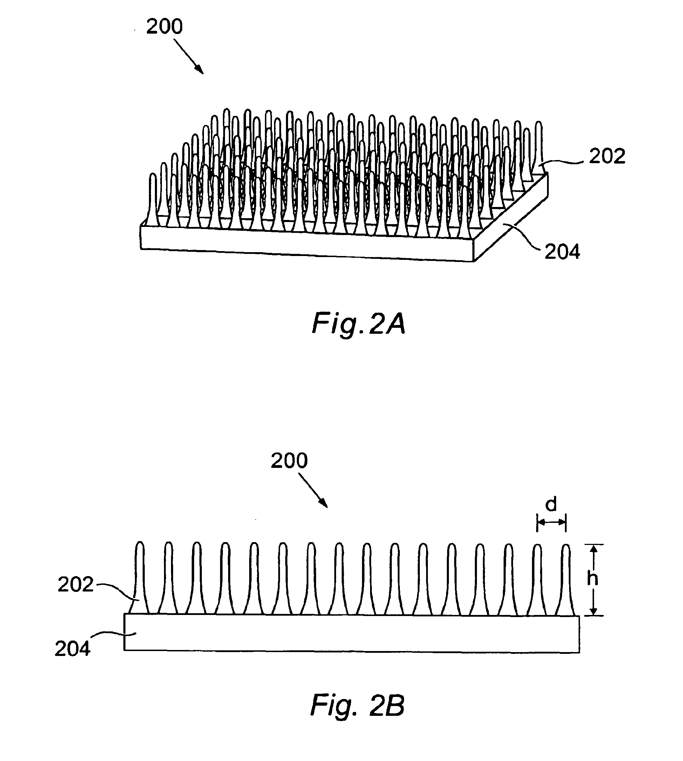

Fig. 2 shows one form of moth eye structure 200 comprising generally conical formations 202 extending from a substrate 204. Other forms of projections are possible, for example pyramidal. The formations may be of varying heights within the structure provided the height h is smaller than the light wavelength of interest. Also, the formations may be in a regular matrix as shown, or irregularly disposed.

The moth eye structure may be made in a lithographic etch or deposition process which is transferred to the refracting medium either directly or by over-moulding. Thus a large scale process for imposing the moth eye structure on the glass substrate wafer can be envisaged. The fact that the material used in the moth eye structure has the same, or nearly the same, refractive properties as the other over-moulded optical components allows it to "disappear" where the required optical refracting components are superimposed either though over-moulding or by gluing. In some systems the moth eye structure may be printed along with the optical components on the substrate glass wafer.

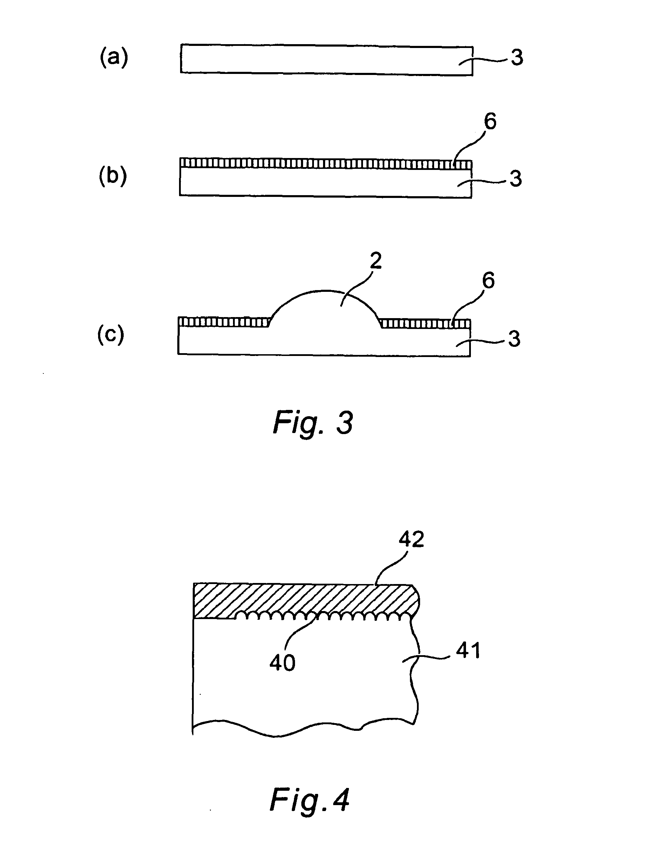

Fig. 3 illustrates one form of the "disappearing" feature. A glass substrate 3 (Fig. 3a) has a moth eye structure 6 formed over its entire surface (Fig. 3b). A lens 2 is then moulded on top of the moth eye structure (Fig. 3c). Since the refractive indices of the elements 2,3,6 are the same or substantially so, the moth eye structure in the area of the lens 2 effectively disappears.

Where the moth eye structure is exposed, it can be coated in an optically absorbent material, such as carbon loaded epoxy resin, to produce a high quality baffle on glass. This is illustrated in Fig. 4, in which a moth eye structure 40 formed on a substrate 41 is covered with an absorber layer 41. The moth eye structure would need to be optimised to cope with the specific optical properties of the absorber.

Alternatively the moth eye structure may be formed by grinding, or sandblasting the optical surfaces of the glass substrate wafer with a fine grit size to produce a fine scattering medium that will lend itself to over-moulding with both the lens feature material and the opaque absorber material. The structure produced will have a pseudo-random nature much as the printed moth eye structure, however it may prove cheaper to manufacture and nearly as effective in reducing stray light when over-moulded with the absorbent material.

One potential extension to this idea is the use of moth eye structures as anti-refection surfaces on the optical elements (i.e. the lens) themselves.

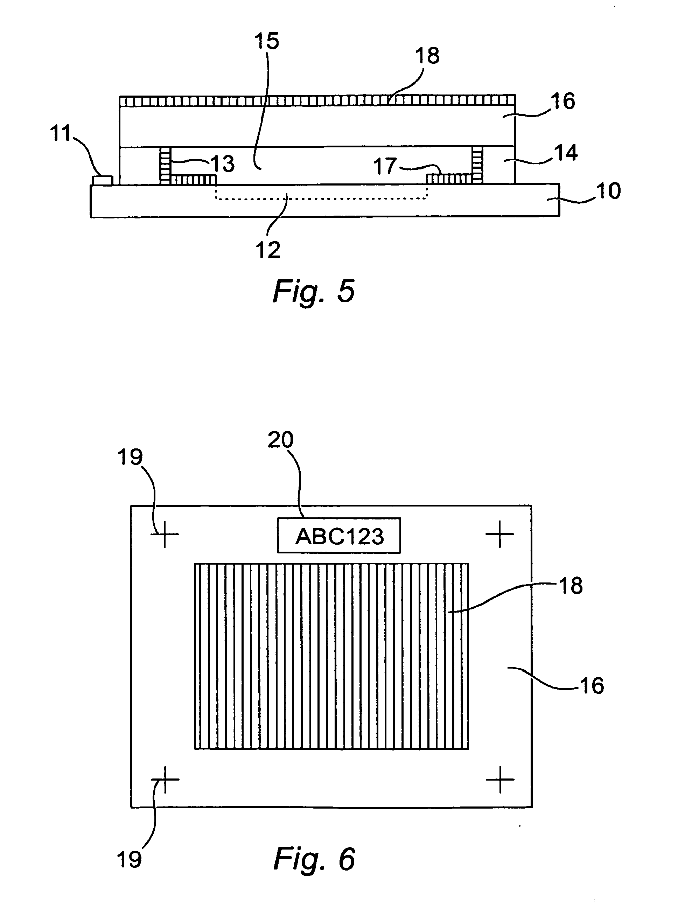

Moth eye structures may also be utilised in relation to air-cavity chip scale packages, as illustrated in Fig. 5. A silicon wafer 10 is provided onto which a CMOS sensor 12 is built by standard semiconductor processes. A spacer member 14, defining a wall structure, is attached to the wafer 10 to hold a fixed "air-cavity" 15 between the sensor surface and a package lid 16 attached to the top of the spacer member 14 over the CMOS sensor 12. The electrical contacts to the CMOS sensor are typically made by routing from custom connection pads on front of the silicon wafer to pads such as that seen at 11. The spacer member 14 and the package lid 16 are typically made from glass, which may be chosen to be expansion-matched to the silicon wafer 10.

The stress problems generated during application of a thin film dielectric coating on the components of the chip scale package currently preclude their use. Thus, with known chip scale package CMOS sensors, the lack of an anti-reflection mechanism causes internal reflections within the glass or the air-cavity in the final product which result in an interference pattern, which can be observed as rings in the final image.

The mutual exclusion of anti-reflection coatings and minimal-stress manufacture can be solved by using a moth eye structure.

The invention allows an anti-reflection structure (minimising the interference pattern formed by the CSP) to be formed internal to the air-cavity of the chip scale package without inducing the stresses in the glass which make it unmanufactureable.

A moth eye structure 13 is formed on the inner walls of the spacer member 14 and a moth eye structure 17 is formed on the regions of the silicon wafer 10 surrounding the CMOS sensor 12 to further reduce internal reflections within the chip scale package. A moth eye structure 18 may also be formed on the outer surface of the package lid 16.

Moth eye structures can reduce the reflectivity of a surface to the region of 1 %.

The application of moth eye structures in chip scale packages and wafer scale lenses brings advantages in that the glass components do not require the same degree of index matching as when standard thin-film coatings are used and therefore allow the designer to concentrate on the mechanical properties of the materials or coatings used.

The application of moth eye structures to air-cavity chip scale packages allows the formation of other structures such as those required for improved alignment and to improve the strength of bonded sections at no extra cost.

The moth eye structure can be generated on the glass surface by the following techniques:-
1. Direct etching onto glass using a mask tuned such as to produce the pseudo-random structure of the moth eye both in depth of etch and in the 2 dimensional pattern.
2. Direct laser ablation of the glass surface.
3. Transfer moulding of the moth eye pattern using a UV set cement based transfer moulding process.
4. Moulding of glass surface to form the moth eye structure using an embossing process directly onto the glass surface. Note that this may be followed by annealing to remove the residual stress in the surface.

The invention also allows for the inclusion of features on the silicon wafer 10 and/or the package lid 16 to aid in alignment, product tracking and the formation of mechanical joints between said components and the spacer member 14.

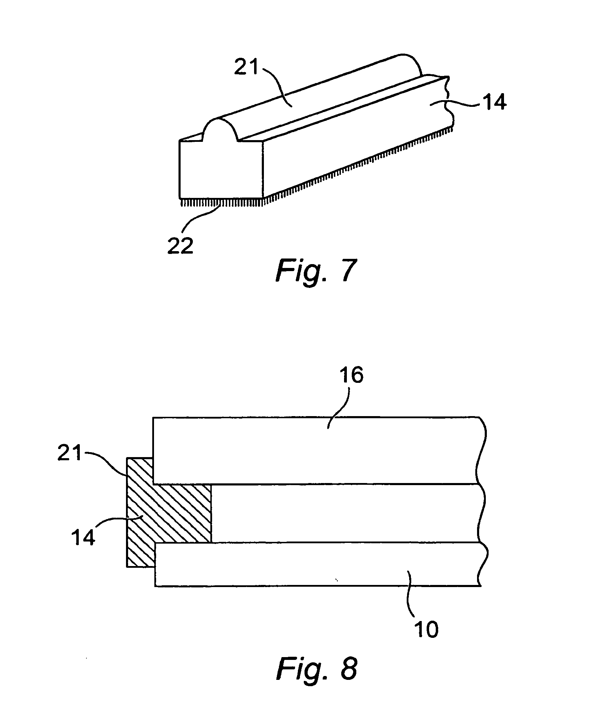

Alignment features can be built in to the glass package lid 16 of the chip scale package at the same time as the moth eye structure is formed. Process control and tracking features can be included in the same manner as the alignment features. These could be markings that allowed either lot or tool tracking through the manufacturing process. For example, Fig. 6 is a plan view of a glass package lid 16 showing a motheye structure 18, embossed markings 19 for use as alignment marks, and embossed or printed indicia 20 forming a lot number or a tool number. Alignment can also be aided by mechanical features. For example, Fig. 7 shows a spacer member 14 formed with upper and lower lips 21 acting as locators for the lid 16 and silicon wafer 10.

Features aiding in the mechanical joint between the spacer member 14 and the silicon wafer 10 and/or the package lid 16 may be provided, such as raised sections to reduce stress at the junction between the spacer member 14 and the adjacent structure or a roughened zone to improve adhesion. Fig. 8 shows a spacer member 14 having a rounded bead section 21 for engagement with the package lid 16 and a roughened lower face 22 for adhering to the silicon wafer 10. Note that for the transfer-moulded implementation there is the potential for the elasticity of the material used to compensate for any stress generated by the chip scale package structure.

The invention is applicable to a broad range of devices. An imaging assembly according to the invention can be incorporated in a wide range of image sensors, which may be incorporated in such devices as a camera, particularly a digital camera, a mobile cellular telephone incorporating a digital camera, and an optical mouse. It will be appreciated that standard techniques may be employed by the man skilled in the art in order to implement the invention in these and other ways.

## Claims

1. An imaging assembly comprising a substrate (5,10); a first substantially transparent optical layer (3,16); at least one spacer member (4,14) wherein the at least one spacer member is arranged between the substrate and the first optical layer to define an air gap (8,15) between the substrate and the first optical layer; wherein a nanoscale relief structure (6,7,13,17) is provided on substantially all non-light transmissive regions of the imaging assembly exposed to said air gap (8,15) to prevent internal reflections within said imaging assembly, the nanoscale relief structure (6,7,13,17) comprising a plurality of projections (202) having a height smaller than the wavelength of the radiation to be imaged by the imaging assembly to prevent unwanted reflections and **characterized in that** the first optical layer (3, 16) has said nanoscale relief structure (6, 7, 13, 17) formed across the whole of one surface, and also has a light-transmissive optical element (2) positioned on top of and in intimate contact with said nanoscale relief surface, wherein the nanoscale relief structure (6, 7, 13 17) and the tight-transmissive optical element (2) have refractive indices which are the same or substantially so, to cause the junction between them to be substantially invisible at the wavelength of the radiation to be imaged by the imaging assembly.

2. An imaging assembly as claimed in claim 1, wherein the nanoscale relief structure (6,7,13,17) comprises a plurality of projections (202) having a height less than the wavelength of visible light, preferably a height of between 200 and 800 nm.

3. An imaging assembly as claimed in any preceding claim, further comprising a solid state image sensor (12) provided or mounted on said substrate.

4. An imaging assembly as claimed in any preceding claim, wherein the imaging assembly comprises a wafer scale lens wherein said first optical layer (3) comprises an at least partially transparent member having an upper surface and a lower surface, a lens (2) being provided on at least one of said upper and lower surfaces, the inner faces of said spacer member (4) facing said air gap being provided with said nanoscale relief structure (6,7,13,17);
the assembly optionally comprising a further spacer member (4) mounted on the upper surface of the optical layer (3), a further optical layer (3) being mounted on said further spacer member to be spaced above said first optical layer, the further optical layer having an upper surface and a lower surface, a lens (2) being provided on at least one of said upper and lower surfaces thereof, the inner faces of said further spacer member (4) facing the gap between said first and further optical layers being provided with said nanoscale relief structure (6,7,13,17); and optionally also comprising a plurality of further spacer members (4) and a plurality of further optical layers (3) arranged in a coaxial stacked relationship upon said first optical layer (3), each further spacer member (4) being provided with said nanoscale relief structure (6,7,13,17) on the inner faces thereof.

5. An imaging assembly as claimed in any preceding claim, wherein the imaging assembly comprises a CMOS image sensor, said substrate comprising a silicon wafer (10) having an image sensor (12) formed thereon, said spacer member (14) comprising a wall structure attached to said substrate to encompass said image sensor (12), said first optical layer comprising a cover (16) attached to said spacer member (14) to define a closed cavity (15) over said image sensor (12), the inner faces of said spacer member (14) and said first optical layer exposed to said cavity (15) being provided with said nanoscale relief structure (6,7,13,17).

6. An imaging assembly as claimed in claim 5, wherein the substrate (10) and/or the optical layer (16) is provided with surface features to aid alignment of the spacer member (14) upon the substrate and/or the optical layer (16) to improve adhesion of the spacer member thereto.

7. An imaging assembly as claimed in claim 6, wherein said surface features comprise a roughened surface region (22) to improve adhesion of the spacer means (14) to the substrate (10) and/or the optical layer (16).

8. An imaging assembly as claimed in claim 6, wherein said surface features comprise raised formations (21) to aid location of the spacer member (14) on the substrate (10) and to reduce stresses at the junction of the spacer member (14) and the substrate (10) and/or the optical layer (16).

9. A method of manufacturing an imaging assembly which comprises a substrate (5, 10), a substantially transparent optical layer (3, 16), and at least one spacer member (4, 14) wherein the at least one spacer member (4, 14) is arranged between the substrate (5, 10) and the optical layer (3, 16) to define an air gap (8,15) between the substrate (5, 10) and the optical layer (3, 16), the method comprising forming a nanoscale relief structure (6,7,13,17) on substantially all non-light transmissive regions of the imaging assembly exposed to said air gap (8,15) to prevent internal reflections within said imaging assembly, said nanoscale relief structure (6,7,13,17) comprising a plurality of projections (202) having a height smaller than the wavelength of the radiation to be imaged by the imaging assembly **characterized in that** the method further comprises forming the nanoscale relief structure (6, 7, 13, 17) across the whole of one surface, and also positioning a light-transmissive optical element (2) on top of and in intimate contact with said nanoscale relief surface, wherein the nanoscale relief structure (6, 7, 13 17) and the light-transmissive optical element (2) have refractive indices which are the same or substantially so, to cause the junction between them to be substantially invisible at the wavelength of the radiation to be imaged by the imaging assembly.

10. A method as claimed in claim 9, wherein said nanoscale relief structure (6,7,13,17) is formed by one or more of direct lithographic etching , laser ablation techniques, transfer moulding, embossing processes, or fine sand blasting or grinding of the surfaces with a fine grit.

11. A method as claimed in claim 10, wherein said nanoscale relief structure (6,7,13,17) is formed in the same step as forming a lens (2) on one or both of said upper and lower surfaces of the optical layer (3, 16).

12. A method as claimed in claim 10, comprising forming said nanoscale relief structure (6,7,13,17) over substantially all of one or both of said upper and lower surfaces and over-moulding one or more optical components (2) on at least a portion of the nanoscale relief structure (6,7,13,17) on one or both of an upper and a lower surface of said optical layer.

13. A method as claimed in any of claims 9 to 12, wherein an image sensor (12) is provided on or mounted on said substrate (5, 10), said method comprising forming said nanoscale relief structure (6,7,13,17) on a region of said substrate (5, 10) around said image sensor (12).

14. A device comprising an imaging assembly as claimed in any of claims 1 to 8; the device being one of a mobile cellular telephone, a camera, a medical device for viewing within a mammalian body, or an optical pointing device.

## Patentansprüche

1. Eine Bildgebungsanordnung, die Folgendes beinhaltet: ein Substrat (5, 10); eine erste im Wesentlichen transparente optische Schicht (3, 16); mindestens ein Abstandselement (4, 14), wobei das mindestens eine Abstandselement zwischen dem Substrat und der ersten optischen Schicht eingerichtet ist, um zwischen dem Substrat und der ersten optischen Schicht einen Luftzwischenraum (8, 15) zu definieren; wobei eine Reliefstruktur (6, 7, 13, 17) im Nanobereich auf im Wesentlichen allen lichtundurchlässigen Bereichen der Bildgebungsanordnung, die dem Luftzwischenraum (8, 15) ausgesetzt sind, bereitgestellt ist, um interne Reflexionen innerhalb der Bildgebungsanordnung zu verhindern, wobei die Reliefstruktur (6, 7, 13, 17) im Nanobereich eine Vielzahl von Erhebungen (202) beinhaltet, die eine Höhe aufweisen, welche geringer als die Wellenlänge der Strahlung ist, die von der Bildgebungsanordnung abgebildet werden soll, um unerwünschte Reflexionen zu verhindern, und **dadurch gekennzeichnet ist, dass** die erste optische Schicht (3, 16) die Reliefstruktur (6, 7, 13, 17) im Nanobereich aufweist, die über die Gesamtheit einer Oberfläche gebildet ist, und auch ein lichtdurchlässiges optisches Element (2) aufweist, das oben auf der Reliefoberfläche im Nanobereich positioniert und in engem Kontakt damit ist, wobei die Reliefstruktur (6, 7, 13, 17) im Nanobereich und das lichtdurchlässige optische Element (2) Brechungsindizes aufweisen, die gleich oder im Wesentlichen gleich sind, um zu verursachen, dass die Kontaktstelle zwischen ihnen bei der Wellenlänge der Strahlung, die von der Bildgebungsanordnung abgebildet werden soll, im Wesentlichen unsichtbar ist.

2. Bildgebungsanordnung gemäß Anspruch 1, wobei die Reliefstruktur (6, 7, 13, 17) im Nanobereich eine Vielzahl von Erhebungen (202) mit einer Höhe, die geringer als die Wellenlänge von sichtbarem Licht ist, vorzugsweise einer Höhe von zwischen 200 und 800 nm, beinhaltet.

3. Bildgebungsanordnung gemäß einem der vorhergehenden Ansprüche, die ferner einen Festkörperbildsensor (12) beinhaltet, der auf dem Substrat bereitgestellt oder darauf montiert ist.

4. Bildgebungsanordnung gemäß einem der vorhergehenden Ansprüche, wobei die Bildgebungsanordnung eine Linse im Waferbereich beinhaltet, wobei die erste optische Schicht (3) ein mindestens teilweise transparentes Element mit einer oberen Oberfläche und einer unteren Oberfläche beinhaltet, wobei eine Linse (2) auf mindestens einer von der oberen und der unteren Oberfläche bereitgestellt ist, wobei die Innenflächen des Abstandselements (4), die dem Luftzwischenraum zugewandt sind, mit der Reliefstruktur (6, 7, 13, 17) im Nanobereich versehen sind;
wobei die Anordnung optional ein weiteres Abstandselement (4), das auf der oberen Oberfläche der optischen Schicht (3) montiert ist, beinhaltet, wobei eine weitere optische Schicht (3) auf dem weiteren Abstandselement montiert ist, um oberhalb der ersten optischen Schicht mit Abstand angeordnet zu sein, wobei die weitere optische Schicht eine obere Oberfläche und eine untere Oberfläche aufweist, wobei eine Linse (2) auf mindestens einer von der oberen und der unteren Oberfläche davon bereitgestellt ist, wobei die Innenflächen des weiteren Abstandselements (4), die dem Zwischenraum zwischen der ersten und den weiteren optischen Schichten zugewandt sind, mit der Reliefstruktur (6, 7, 13, 17) im Nanobereich versehen sind; und wobei sie optional auch eine Vielzahl von weiteren Abstandselementen (4) und eine Vielzahl von weiteren optischen Schichten (3) beinhaltet, die auf der ersten optischen Schicht (3) in einer koaxial gestapelten Beziehung eingerichtet sind, wobei jedes weitere Abstandselement (4) auf den Innenflächen davon mit der Reliefstruktur (6, 7, 13, 17) im Nanobereich versehen ist.

5. Bildgebungsanordnung gemäß einem der vorhergehenden Ansprüche, wobei die Bildgebungsanordnung einen CMOS-Bildsensor beinhaltet, wobei das Substrat einen Siliziumwafer (10) mit einem darauf gebildeten Bildsensor (12) beinhaltet, wobei das Abstandselement (14) eine Wandstruktur beinhaltet, die an dem Substrat befestigt ist, um den Bildsensor (12) zu umgeben, wobei die erste optische Schicht eine Abdeckung (16) beinhaltet, die an dem Abstandselement (14) befestigt ist, um einen geschlossenen Hohlraum (15) über dem Bildsensor (12) zu definieren, wobei die Innenflächen des Abstandselements (14) und die erste optische Schicht, welche dem Hohlraum (15) ausgesetzt sind, mit der Reliefstruktur (6, 7, 13, 17) im Nanobereich versehen sind.

6. Bildgebungsanordnung gemäß Anspruch 5, wobei das Substrat (10) und/oder die optische Schicht (16) mit Oberflächenmerkmalen versehen ist/sind, um bei der Ausrichtung des Abstandselements (14) auf dem Substrat und/oder der optischen Schicht (16) zu helfen, um die Haftung des Abstandselements daran zu verbessern.

7. Bildgebungsanordnung gemäß Anspruch 6, wobei die Oberflächenmerkmale einen gerauten Oberflächenbereich (22) beinhalten, um die Haftung des Abstandsmittels (14) an dem Substrat (10) und/oder der optischen Schicht (16) zu verbessern.

8. Bildgebungsanordnung gemäß Anspruch 6, wobei die Oberflächenmerkmale erhöhte Formationen (21) beinhalten, um bei der Platzierung des Abstandselements (14) auf dem Substrat (10) zu helfen und um Belastungen an der Kontaktstelle des Abstandselements (14) und des Substrats (10) und/oder der optischen Schicht (16) zu verringern.

9. Ein Verfahren zur Herstellung einer Bildgebungsanordnung, die Folgendes beinhaltet:
ein Substrat (5, 10), eine im Wesentlichen transparente optische Schicht (3, 16) und
mindestens ein Abstandselement (4, 14), wobei das mindestens eine Abstandselement (4, 14) zwischen dem Substrat (5, 10) und der ersten optischen Schicht (3, 16) eingerichtet ist, um zwischen dem Substrat (5, 10) und der optischen Schicht (3, 16) einen Luftzwischenraum (8, 15) zu definieren, wobei das Verfahren das Bilden einer Reliefstruktur (6, 7, 13, 17) im Nanobereich auf im Wesentlichen allen lichtundurchlässigen Bereichen der Bildgebungsanordnung, die dem Luftzwischenraum (8, 15) ausgesetzt sind, beinhaltet, um interne Reflexionen innerhalb der Bildgebungsanordnung zu verhindern, wobei die Reliefstruktur (6, 7, 13, 17) im Nanobereich eine Vielzahl von Erhebungen (202) beinhaltet, die eine Höhe aufweisen,
welche geringer als die Wellenlänge der Strahlung ist, die von der Bildgebungsanordnung abgebildet werden soll, **dadurch gekennzeichnet, dass** das Verfahren ferner das Bilden der Reliefstruktur (6, 7, 13, 17) im Nanobereich über die Gesamtheit einer Oberfläche und auch das Positionieren eines lichtdurchlässigen optischen Elements (2) oben auf und in engem Kontakt mit der Reliefoberfläche im Nanobereich beinhaltet, wobei die Reliefstruktur (6, 7, 13, 17) im Nanobereich und das lichtdurchlässige optische Element (2) Brechungsindizes aufweisen, die gleich oder im Wesentlichen gleich sind, um zu verursachen, dass die Kontaktstelle zwischen ihnen bei der Wellenlänge der Strahlung, die von der Bildgebungsanordnung abgebildet werden soll, im Wesentlichen unsichtbar ist.

10. Verfahren gemäß Anspruch 9, wobei die Reliefstruktur (6, 7, 13, 17) im Nanobereich durch eines oder mehrere aus Folgendem gebildet ist: Lithographieätzen, Laserablationstechniken, Spritzpressen, Prägeverfahren oder Feinsandstrahlen oder Schleifen der Oberflächen mit einem feinen Schleifmittel.

11. Verfahren gemäß Anspruch 10, wobei die Reliefstruktur (6, 7, 13, 17) im Nanobereich im gleichen Schritt wie das Bilden einer Linse (2) auf einer oder beiden von der oberen und unteren Oberfläche der optischen Schicht (3, 16) gebildet wird.

12. Verfahren gemäß Anspruch 10, das das Bilden der Reliefstruktur (6, 7, 13, 17) im Nanobereich über im Wesentlichen die Gänze einer oder beiden von der oberen und unteren Oberfläche und das Umspritzen einer oder mehrerer optischer Komponenten (2) auf mindestens einem Abschnitt der Reliefstruktur (6, 7, 13, 17) im Nanobereich auf einer oder beiden von einer oberen und einer unteren Oberfläche der optischen Schicht beinhaltet.

13. Verfahren gemäß einem der Ansprüche 9 bis 12, wobei ein Bildsensor (12) auf dem Substrat (5, 10) bereitgestellt oder darauf montiert ist, wobei das Verfahren das Bilden der Reliefstruktur (6, 7, 13, 17) im Nanobereich auf einem Bereich des Substrats (5, 10) um den Bildsensor (12) beinhaltet.

14. Eine Vorrichtung, die eine Bildgebungsanordnung gemäß einem der Ansprüche 1 bis 8 beinhaltet; wobei die Vorrichtung eines von Folgendem ist: ein Mobiltelefon, eine Kamera, eine medizinische Vorrichtung zum Sehen innerhalb eines Körpers eines Säugetiers oder eine optische Zeigevorrichtung.

## Revendications

1. Un ensemble d'imagerie comprenant un substrat (5, 10) ; une première couche optique substantiellement transparente (3, 16) ; au moins un élément espaceur (4, 14) cet au moins un élément espaceur étant arrangé entre le substrat et la première couche optique afin de définir un intervalle d'air (8, 15) entre le substrat et la première couche optique ; une structure en relief nanométrique (6, 7, 13, 17) étant prévue sur substantiellement toutes les régions non transmissives de lumière de l'ensemble d'imagerie exposées audit intervalle d'air (8, 15) afin d'empêcher des réflexions internes au sein dudit ensemble d'imagerie, la structure en relief nanométrique (6, 7, 13, 17) comprenant une pluralité de saillies (202) ayant une hauteur plus petite que la longueur d'onde du rayonnement à imager par l'ensemble d'imagerie afin d'empêcher des réflexions non souhaitées et **caractérisé en ce que** la première couche optique (3, 16) a ladite structure en relief nanométrique (6, 7, 13, 17) formée sur l'intégralité d'une surface, et a également un élément optique transmissif de lumière (2) positionné sur le dessus de et en contact étroit avec ladite surface en relief nanométrique, la structure en relief nanométrique (6, 7, 13, 17) et l'élément optique transmissif de lumière (2) ayant des indices de réfraction qui sont identiques ou substantiellement identiques, pour faire que la jonction entre eux soit substantiellement invisible à la longueur d'onde du rayonnement à imager par l'ensemble d'imagerie.

2. Un ensemble d'imagerie tel que revendiqué dans la revendication 1, dans lequel la structure en relief nanométrique (6, 7, 13, 17) comprend une pluralité de saillies (202) ayant une hauteur inférieure à la longueur d'onde de la lumière visible, de préférence une hauteur comprise entre 200 et 800 nm.

3. Un ensemble d'imagerie tel que revendiqué dans n'importe quelle revendication précédente, comprenant en outre un capteur d'image à l'état solide (12) prévu ou monté sur ledit substrat.

4. Un ensemble d'imagerie tel que revendiqué dans n'importe quelle revendication précédente, l'ensemble d'imagerie comprenant une lentille à l'échelle d'une plaquette où ladite première couche optique (3) comprend un élément au moins en partie transparent ayant une surface supérieure et une surface inférieure, une lentille (2) étant prévue sur au moins soit ladite surface supérieure, soit ladite surface inférieure, les faces internes dudit élément espaceur (4) faisant face audit intervalle d'air étant pourvues de ladite structure en relief nanométrique (6, 7, 13, 17) ;
l'ensemble comprenant facultativement un élément espaceur supplémentaire (4) monté sur la surface supérieure de la couche optique (3), une couche optique supplémentaire (3) étant montée sur ledit élément espaceur supplémentaire afin d'être espacée au-dessus de ladite première couche optique, la couche optique supplémentaire ayant une surface supérieure et une surface inférieure, une lentille (2) étant prévue sur au moins soit ladite surface supérieure, soit ladite surface inférieure de celle-ci, les faces internes dudit élément espaceur supplémentaire (4) faisant face à l'intervalle entre ladite première couche optique et ladite couche optique supplémentaire étant pourvues de ladite structure en relief nanométrique (6, 7, 13, 17) ; et comprenant facultativement aussi une pluralité d'éléments espaceurs supplémentaires (4) et une pluralité de couches optiques supplémentaires (3) arrangées selon un rapport d'empilement coaxial sur ladite première couche optique (3), chaque élément espaceur supplémentaire (4) étant pourvu de ladite structure en relief nanométrique (6, 7, 13, 17) sur les faces internes de celui-ci.

5. Un ensemble d'imagerie tel que revendiqué dans n'importe quelle revendication précédente, l'ensemble d'imagerie comprenant un capteur d'image CMOS, ledit substrat comprenant une plaquette de silicium (10) ayant un capteur d'image (12) formé sur celle-ci, ledit élément espaceur (14) comprenant une structure de paroi attachée audit substrat pour englober ledit capteur d'image (12), ladite première couche optique comprenant une couverture (16) attachée audit élément espaceur (14) pour définir une cavité fermée (15) par-dessus ledit capteur d'image (12), les faces internes dudit élément espaceur (14) et ladite première couche optique exposées à ladite cavité (15) étant pourvues de ladite structure en relief nanométrique (6, 7, 13, 17).

6. Un ensemble d'imagerie tel que revendiqué dans la revendication 5, dans lequel le substrat (10) et / ou la couche optique (16) sont pourvus de particularités de surface pour aider à aligner l'élément espaceur (14) sur le substrat et / ou la couche optique (16) pour améliorer l'adhésion de l'élément espaceur sur ceux-ci.

7. Un ensemble d'imagerie tel que revendiqué dans la revendication 6, dans lequel lesdites particularités de surface comprennent une région de surface rugosifiée (22) pour améliorer l'adhésion du moyen espaceur (14) sur le substrat (10) et / ou la couche optique (16).

8. Un ensemble d'imagerie tel que revendiqué dans la revendication 6, dans lequel lesdites particularités de surface comprennent des formations surélevées (21) pour aider à placer l'élément espaceur (14) sur le substrat (10) et pour réduire les contraintes à la jonction de l'élément espaceur (14) et du substrat (10) et / ou de la couche optique (16).

9. Une méthode de fabrication d'un ensemble d'imagerie qui comprend un substrat (5, 10), une couche optique substantiellement transparente (3, 16), et au moins un élément espaceur (4, 14), cet au moins un élément espaceur (4, 14) étant arrangé entre le substrat (5, 10) et la couche optique (3, 16) afin de définir un intervalle d'air (8, 15) entre le substrat (5, 10) et la couche optique (3, 16), la méthode comprenant former une structure en relief nanométrique (6, 7, 13, 17) sur substantiellement toutes les régions non transmissives de lumière de l'ensemble d'imagerie exposées audit intervalle d'air (8, 15) afin d'empêcher des réflexions internes au sein dudit ensemble d'imagerie, ladite structure en relief nanométrique (6, 7, 13, 17) comprenant une pluralité de saillies (202) ayant une hauteur plus petite que la longueur d'onde du rayonnement à imager par l'ensemble d'imagerie **caractérisée en ce que** la méthode comprend en outre former la structure en relief nanométrique (6, 7, 13, 17) sur l'intégralité d'une surface, et également positionner un élément optique transmissif de lumière (2) sur le dessus de et en contact étroit avec ladite surface en relief nanométrique, la structure en relief nanométrique (6, 7, 13, 17) et l'élément optique transmissif de lumière (2) ayant des indices de réfraction qui sont identiques ou substantiellement identiques, pour faire que la jonction entre eux soit substantiellement invisible à la longueur d'onde du rayonnement à imager par l'ensemble d'imagerie.

10. Une méthode telle que revendiquée dans la revendication 9, dans laquelle ladite structure en relief nanométrique (6, 7, 13, 17) est formée grâce à une ou plusieurs techniques parmi la gravure lithographique directe, des techniques d'ablation par laser, le moulage par transfert, des procédés de gaufrage, ou le décapage au sable fin ou le ponçage des surfaces avec un grain fin.

11. Une méthode telle que revendiquée dans la revendication 10, dans laquelle ladite structure en relief nanométrique (6, 7, 13, 17) est formée à la même étape que la formation d'une lentille (2) sur une surface, ou les deux, d'entre lesdites surfaces supérieure et inférieure de la couche optique (3, 16).

12. Une méthode telle que revendiquée dans la revendication 10, comprenant former ladite structure en relief nanométrique (6, 7, 13, 17) sur substantiellement la totalité d'une surface, ou des deux, d'entre lesdites surfaces supérieure et inférieure et sur-mouler un ou plusieurs composants optiques (2) sur au moins une portion de la structure en relief nanométrique (6, 7, 13, 17) sur une surface, ou les deux, d'entre une surface supérieure et une surface inférieure de ladite couche optique.

13. Une méthode telle que revendiquée dans n'importe lesquelles des revendications 9 à 12, dans laquelle un capteur d'image (12) est prévu sur ou monté sur ledit substrat (5, 10), ladite méthode comprenant former ladite structure en relief nanométrique (6, 7, 13, 17) sur une région dudit substrat (5, 10) autour dudit capteur d'image (12).

14. Un dispositif comprenant un ensemble d'imagerie tel que revendiqué dans n'importe lesquelles des revendications 1 à 8 ; le dispositif étant soit un téléphone mobile cellulaire, soit un appareil photo, soit un dispositif médical pour regarder à l'intérieur d'un corps de mammifère, soit un dispositif pointeur optique.
